# FASCICULE DE BREVET EUROPEEN

(11) **EP 2 369 226 B1**
(45) Date de publication et mention de la délivrance du brevet: **07.06.2017**
(21) Numéro de dépôt: 10162567.1
(22) Date de dépôt: 11.05.2010
(51) Int. Cl.: F21V 29/00, F28F 3/02, H01L 23/367, F21Y 115/10

(54) **Dispositif d'éclairage comprenant au moins une diode électroluminescente et un système de refroidissement à ailettes**
Beleuchtungsvorrichtung, die mindestens eine Elektrolumineszenzdiode und ein Kühlungssystem mit Kühlrippen enthält
Lighting device including at least one light-emitting diode and a cooling system with fins

(30) Priorité: 16.03.2010 LB 894810
(43) Date de publication de la demande: 28.09.2011
(73) Titulaire: Araman, Antoine, 2604-6101 Beyrouth-Maten (LB)
(72) Inventeur: Araman, Antoine, 2604-6101 Beyrouth-Maten (LB)
(74) Mandataire: Intès, Didier Gérard André

(56) Documents cités:
- FR-A- 1 355 802
- FR-A3- 2 774 465
- JP-A- 2003 198 171
- US-A- 5 020 586
- US-A- 6 062 301
- US-A- 6 125 921
- US-A1- 2002 020 523
- US-A1- 2002 095 788
- US-A1- 2004 182 552
- US-A1- 2009 052 177
- US-B1- 6 324 061
- US-B1- 6 330 906

## Description

L'invention se rapporte à un dispositif d'éclairage comprenant au moins une diode électroluminescente, notamment un dispositif d'éclairage utilisant au moins une telle diode à haut rendement lumineux. L'invention concerne plus particulièrement une structure particulièrement simple et peu coûteuse pour le refroidissement d'une telle diode, permettant de limiter sa température de fonctionnement et par conséquent d'augmenter son efficacité et sa durée de vie.

On assiste actuellement à une très grande mutation dans le domaine de l'éclairage, grâce aux performances, sans cesse améliorées, des diodes électroluminescentes plus connues sous l'abréviation LEDs. Depuis plusieurs années, on propose des diodes électroluminescentes présentant individuellement un rendement lumineux limité en sorte qu'il est nécessaire d'en regrouper plusieurs côte à côte pour obtenir un pouvoir d'éclairage conséquent, nettement inférieur, cependant, à celui des meilleures lampes à incandescence.

Plus récemment, sont apparues des diodes électroluminescentes à haut rendement lumineux capables de rivaliser avec les lampes à incandescence, avec la perspective de les remplacer, progressivement, dans les prochaines années.

Cependant, une diode électroluminescente de ce type nécessite, de préférence, d'être refroidie pour stabiliser sa température de fonctionnement à une valeur donnée par exemple, de l'ordre de 60 à 70°C.

Dans le domaine des semi-conducteurs, par exemple, il est connu depuis longtemps de refroidir les composants de puissance en les montant sur des radiateurs avec un couplage thermique fort pour dissiper la chaleur dégagée, par conduction puis convection naturelle d'air. La demande de brevet US2009/0052177 présente un dispositif d'éclairage avec des diodes électroluminescentes et un radiateur de refroidissement selon le préambule de la revendication 1. Les radiateurs proposés sont souvent soit moulés dans un alliage d'aluminium, soit extrudés dans un alliage comparable, le profilé extrudé étant ensuite coupé à une longueur voulue correspondant à la puissance thermique à dissiper. Les radiateurs moulés ou extrudés sont des composants très coûteux. Dans le cas du moulage, on doit prévoir des moules pour toutes les dimensions requises et les cadences de production sont difficilement conciliables avec les nécessités du marché de l'éclairage, tel qu'il se présente avec l'apparition de ces nouvelles LEDs. L'extrusion est également un procédé coûteux et compliqué à mettre en oeuvre. Dans les deux cas, les ailettes de refroidissement qui sont définies dans de tels d'extrusion elles-mêmes, pour une surface d'échange thermique donnée. Il en résulte un radiateur plus lourd que ce qu'il serait possible d'obtenir, à qualité de refroidissement par convection égale, avec un radiateur présentant des ailettes plus minces. La masse de métal requise, généralement de l'aluminium assez coûteux, fait que ce radiateur de refroidissement ne peut être optimisé et que son coût de revient reste nécessairement élevé.

L'invention permet de résoudre tous ces problèmes en proposant un dispositif d'éclairage à LEDs muni d'un radiateur de refroidissement de conception simple, peu coûteux et facile à fabriquer.

Plus particulièrement, l'invention concerne un dispositif d'éclairage comprenant au moins une diode électroluminescente, caractérisé en ce qu'il comporte un radiateur de refroidissement de ladite diode, comprenant un corps principal à profil en U constitué d'une base et de deux bandes parallèles espacées, défini dans un matériau thermiquement conducteur et des ailettes définies dans un matériau thermiquement conducteur, agencées parallèlement les unes aux autres dans l'espace délimité entre les deux bandes et ladite base et en ce que lesdites ailettes sont espacées les unes des autres par au moins deux systèmes d'entretoisement thermiquement conducteurs, en ce que chaque système d'entretoisement est connecté par ses extrémités auxdites bandes parallèles du corps principal et comprend des entretoises en matériau thermiquement conducteur disposées entre les ailettes selon un montage serré assurant une bonne conduction de la chaleur entre le corps principal et les ailettes, ladite diode électroluminescente étant fixée avec contact thermique à ladite base.

Les éléments constitutifs du radiateur, qui viennent d'être énoncés ci-dessus sont tous des éléments de structure extrêmement simples. Par exemple, le corps principal sera avantageusement réalisé à partir d'une tôle métallique pliée à angle droit, selon deux lignes parallèles, définissant le profil en U précité. Les ailettes seront agencées dans le volume défini par la base et les bandes parallèles. De même, les ailettes peuvent être des plaques découpées à partir d'une tôle métallique. Ainsi, tous les éléments appelés à réaliser les échanges thermiques par convection naturelle avec l'air ambiant peuvent être produits à partir de feuillard métallique, par exemple en aluminium ou alliage d'aluminium. L'outillage est traditionnel et facilement disponible partout. On peut facilement adapter tout changement de dimensions (épaisseur, longueur, largeur) en fonction de la puissance thermique à dissiper et aussi pour tenir compte des caractéristiques esthétiques du luminaire auquel le radiateur est adapté, aucune transformation des outils de fabrication n'étant requise.

D'autres métaux peuvent être utilisés, y compris des métaux moins coûteux que l'aluminium.

Toutes les ailettes de refroidissement peuvent avoir une épaisseur assez faible, de l'ordre du millimètre ou moins, difficile, voire impossible à obtenir par les techniques de moulage ou d'extrusion.

Chaque système d'entretoisement précité comporte une tige, s'étendant perpendiculairement auxdites bandes du corps principal et fixée à celles-ci. Les tiges traversent des trous des ailettes précitées tandis que des entretoises tubulaires sont engagées sur ladite tige entre les ailettes.

L'épaisseur des ailettes et la longueur des entretoises sont calculées pour que le montage de la tige entraîne le serrage des ailettes et des entretoises entre elles assurant ainsi une bonne conduction de la chaleur entre le corps principal et les ailettes.

Avantageusement, ladite tige est une vis ou une tige filetée boulonnée entre lesdites bandes parallèles en serrant les entretoises et les ailettes entre elles.

Les entretoises tubulaires sont de préférence en cuivre, laiton ou alliage analogue. Elles peuvent aussi être en aluminium ou alliage d'aluminium.

Pour faciliter l'insertion des ailettes entre les entretoises, avant serrage de la vis ou tige filetée, il est avantageux que les trous de chaque ailette s'étendent jusqu'à un bord de celle-ci. Chaque trou a donc la forme d'une fente ouverte.

Selon une autre caractéristique avantageuse, la base comporte des trous, de préférence des fentes, pour favoriser les échanges thermiques avec les ailettes par convection d'air.

L'invention sera mieux comprise et d'autres avantages de celle-ci apparaîtront plus clairement à la lumière de la description qui va suivre de plusieurs modes de réalisation d'un dispositif d'éclairage conforme à son principe, donnée uniquement à titre d'exemple et faite en référence aux dessins annexés, dans lesquels :

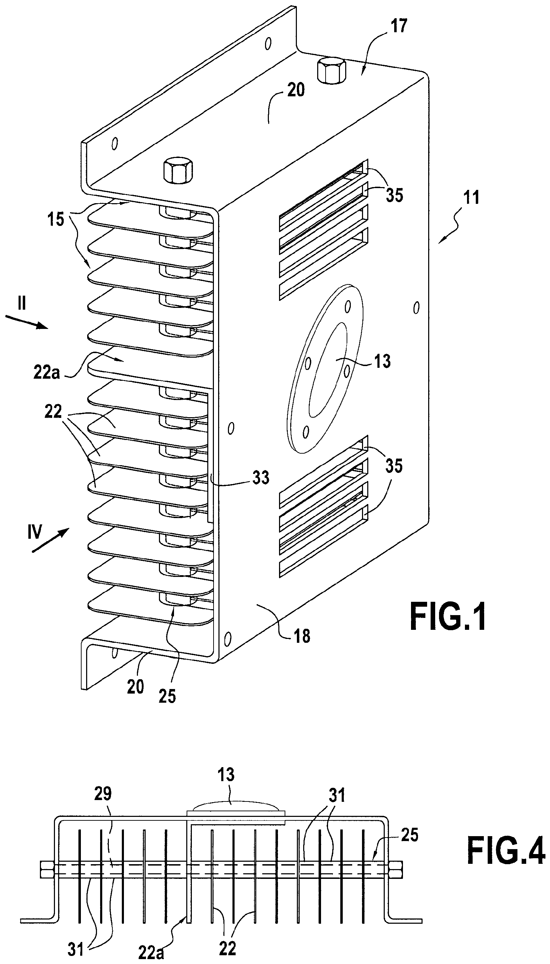

- la figure 1 est une vue générale en perspective d'un premier mode de réalisation d'un dispositif d'éclairage conforme à l'invention ; son principe, donnée uniquement à titre d'exemple et faite en référence aux dessins annexés, dans lesquels :
   - la figure 1 est une vue générale en perspective d'un premier mode de réalisation d'un dispositif d'éclairage conforme à l'invention ;
   - la figure 2 est une vue selon la flèche II de la figure 1 ;
   - la figure 3 est une vue en perspective des éléments du radiateur, illustrant le montage ;
   - la figure 4 est une vue selon la flèche IV de la figure 1 ;
   - la figure 5 est une vue générale en perspective d'un autre mode de réalisation, portant plusieurs diodes électroluminescentes régulièrement espacées ; et
   - la figure 6 est une vue en perspective selon la flèche VI de la figure 5.

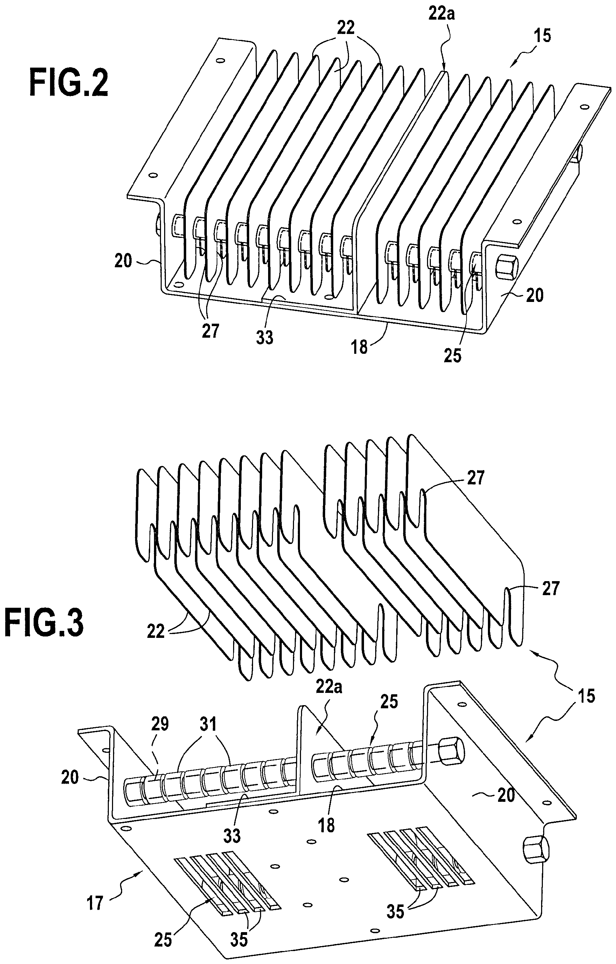

En se reportant aux dessins et plus particulièrement aux figures 1 à 4 relatives au premier mode de réalisation, on a représenté un dispositif d'éclairage 11 comprenant une diode électroluminescente 13, avantageusement une diode LED de haut rendement lumineux. Cette diode est associée à un radiateur de refroidissement 15 essentiellement constitué, selon l'exemple, de composants découpés dans de la tôle métallique, notamment de la tôle d'aluminium ou d'alliage d'aluminium, certains étant ensuite pliés et/ou percés. Les opérations réalisées sur ces éléments appelés à constituer la surface d'échange thermique sont toutes des opérations simples telles que le découpage, le pliage et le poinçonnage, opérées sur de la tôle mince. Comme représenté, le radiateur de refroidissement comprend un corps principal 17 à profil en U constitué d'une base 18 et de deux bandes parallèles 20 espacées. Des ailettes 22 plates, sont agencées parallèlement les unes aux autres dans l'espace délimité entre les deux bandes 20 et ladite base 18 du corps principal 17.

Selon un exemple non limitatif, le corps principal est réalisé à partir d'une feuille d'aluminium ou d'alliage d'aluminium de 1,25 mm d'épaisseur tandis que les ailettes sont découpées dans une feuille d'aluminium ou d'alliage d'aluminium de 5/10^{ème} de millimètre d'épaisseur. Ces ailettes 22 sont espacées les unes des autres par au moins deux systèmes d'entretoisement 25 thermiquement conducteurs, chacun étant connecté par ses extrémités auxdites bandes parallèles 20 du corps principal 17. La diode électroluminescente 13 est fixée avec contact thermique à la base 18 du corps principal. Dans l'exemple représenté, la base est sensiblement carrée et elle porte au moins une diode électroluminescente 13 à haut rendement, fixée sensiblement en son milieu, dans des conditions de couplage thermique permettant un bon écoulement de la chaleur entre la diode et la base. Comme représenté, les ailettes sont percées de trous 27 situés à des emplacements choisis pour leur assemblage aux systèmes d'entretoisement 25.

Un tel système d'entretoisement 25 comporte une tige 29 en l'occurrence ici une vis ou une tige filetée, s'étendant perpendiculairement aux bandes et fixée à celles-ci. Les tiges traversent des trous 27 précités des ailettes et des entretoises tubulaires 31, sont engagées sur la tige 29, entre les ailettes 22.

Puisque la tige 29 est avantageusement une vis ou une tige filetée, elle peut être boulonnée entre lesdites bandes parallèles du corps principal en serrant les entretoises 31 et les ailettes 22 entre elles. Ces entretoises sont en matériau bon conducteur de la chaleur, par exemple en cuivre, laiton ou alliage analogue.

Les trous 27 peuvent être à contour fermé (ronds) mais, selon une caractéristique avantageuse, les trous 27 de chaque ailette (permettant de les assembler aux systèmes d'entretoisement) s'étendent jusqu'à un bord de celle-ci, comme représenté. Chaque trou 27 forme ainsi une fente ouverte. Ceci facilite grandement le montage puisqu'il suffit d'engager la vis ou tige filetée entre les deux bandes parallèles après y avoir "enfilé" le nombre voulu d'entretoises, puis d'insérer les ailettes entre les entretoises et enfin de boulonner la vis ou la tige filetée de façon à serrer entre elles les ailettes et les entretoises. Les systèmes d'entretoisement, après serrage, réalisent un bon couplage thermique, par conduction, entre le corps principal 17 et les ailettes 22.

Selon un mode de réalisation possible, on peut néanmoins prévoir une fixation directe entre au moins une ailette 22a et la base 18 du corps principal 17. Cette ailette a alors un profil en L de façon à définir une embase allongée 33 s'étendant longitudinalement et cette embase allongée est fixée à la base du corps principal à profil en U, par boulonnage, rivetage ou tout autre moyen. On établit ainsi une liaison directe par conduction entre la base du corps principal et cette ailette 22a particulière. Dans l'exemple représenté, cette ailette spéciale à profil en L se situe de préférence sensiblement au milieu de l'espace défini par le corps principal de sorte qu'elle est fixée à la base de celui-ci, au plus près de l'emplacement de la LED.

Comme représenté, la base 18 comporte avantageusement des trous 35, de préférence des fentes pour favoriser les échanges thermiques avec les ailettes, par convection d'air. La LED est fixée à la base 18 sur la face extérieure de celle-ci, opposée à l'espace où sont agencées les ailettes. Ainsi, si le dispositif est placé en hauteur, par exemple intégré à un faux plafond, les ailettes ne sont pas visibles.

Bien entendu, on peut aussi installer plusieurs LEDs sur le mode de réalisation à base carrée décrit en référence aux figures 1 à 4, en changeant les emplacements des trous ou fentes 35.

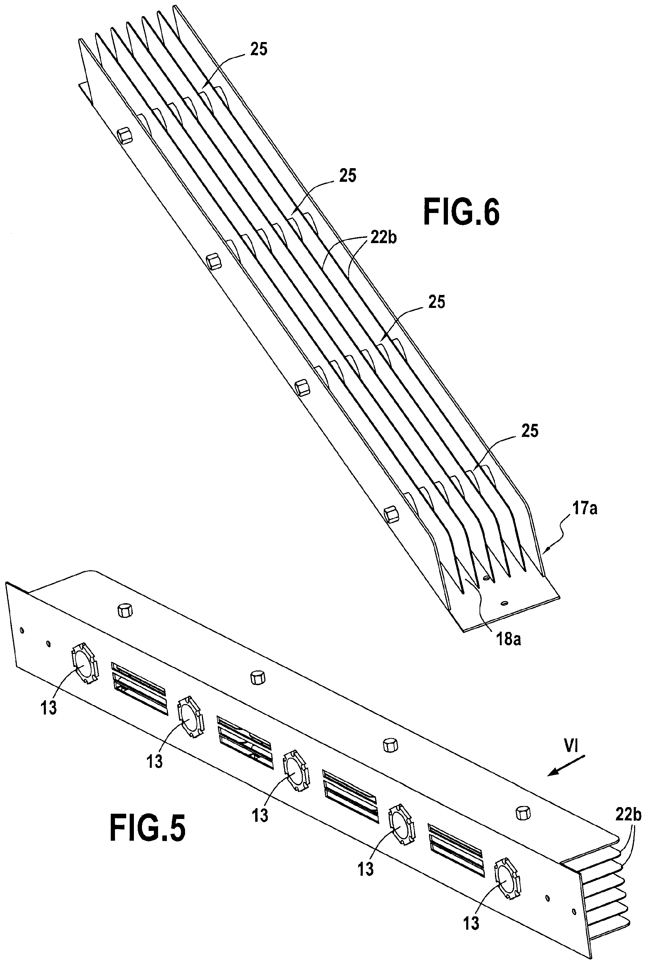

Le mode de réalisation des figures 5 et 6 se distingue du précédent par le fait que la base 18a du corps principal 17a a la forme d'un rectangle allongé et en ce qu'elle porte plusieurs diodes électroluminescentes 13 régulièrement espacées le long de la direction longitudinale de celle-ci. Par voie de conséquence, le corps principal 17a a aussi une forme allongée, de même que les ailettes 22b. Celles-ci sont maintenues par un plus grand nombre de systèmes d'entretoisement 25, régulièrement espacés. Cette variante permet, par exemple, de remplacer un tube fluorescent. Il peut être intégré à un système formant réflecteur (non représenté) appelé à remplacer une dalle de faux plafond, par exemple.

## Revendications

1. Dispositif d'éclairage comprenant au moins une diode électroluminescente (13) et un radiateur de refroidissement de ladite diode, **caractérisé en ce que** le radiateur comprend un corps principal (17) à profil en U constitué d'une base (18) et de deux bandes parallèles (20) espacées, défini dans un matériau thermiquement conducteur et des ailettes (22) définies dans un matériau thermiquement conducteur, agencées parallèlement les unes aux autres dans l'espace délimité entre les deux bandes et ladite base et **en ce que** lesdites ailettes sont espacées les unes des autres par au moins deux systèmes d'entretoisement (25) thermiquement conducteurs, **en ce que** chaque système d'entretoisement est connecté par ses extrémités auxdites bandes parallèles du corps principal et comprend une tige (29) s'étendant perpendiculairement et fixée auxdites bandes parallèles du corps principal et traversant des trous (27) des ailettes, et des entretoises tubulaires (31) en matériau thermiquement conducteur engagées sur la tige (29) et disposées entre les ailettes selon un montage serré par la tige (29) assurant une bonne conduction de la chaleur entre le corps principal et les ailettes, ladite diode électroluminescente étant fixée avec contact thermique à ladite base.

2. Dispositif selon la revendication 1, **caractérisé en ce que** ledit corps principal (17) est réalisé à partir d'une tôle métallique pliée, à angle droit, selon deux lignes parallèles.

3. Dispositif selon la revendication 1 ou 2, **caractérisé en ce que** lesdites ailettes (22) sont des plaques découpées à partir d'une tôle métallique.

4. Dispositif selon l'une quelconque des revendications précédentes, **caractérisé en ce que** ladite tige (29) est une vis ou tige filetée, boulonnée entre lesdites bandes parallèles (20) en serrant les entretoises (31) et les ailettes (22) entre elles.

5. Dispositif selon l'une des revendications précédentes, **caractérisé en ce que** ledit corps principal (17) est en aluminium ou alliage à base d'aluminium.

6. Dispositif selon l'une des revendications précédentes, **caractérisé en ce que** lesdites ailettes (22) sont en aluminium ou alliage à base d'aluminium.

7. Dispositif selon l'une des revendications précédentes, **caractérisé en ce que** lesdites entretoises tubulaires sont en cuivre, laiton ou analogues.

8. Dispositif selon l'une des revendications précédentes, **caractérisé en ce que** les trous de chaque ailette précitée s'étendent jusqu'à un bord de celle-ci, formant une fente ouverte, pour faciliter l'insertion des ailettes entre les entretoises, avant serrage de ladite vis ou tige filetée.

9. Dispositif selon l'une des revendications précédentes, **caractérisé en ce qu'**au moins une ailette (22a) a un profil en L, de façon à définir une embase allongée (33) s'étendant longitudinalement et **en ce que** cette embase allongée est fixée à la base (18) dudit corps principal à profil en U.

10. Dispositif selon l'une des revendications précédentes, **caractérisé en ce que** ladite base (18) comporte des trous (35), de préférence des fentes pour favoriser les échanges thermiques avec les ailettes, par convection d'air.

11. Dispositif selon l'une des revendications précédentes, **caractérisé en ce que** ladite base (18) est sensiblement carrée et **en ce qu'**elle porte au moins une diode électroluminescente montée sensiblement en son milieu.

12. Dispositif selon l'une des revendications 1 à 10, **caractérisé en ce que** ladite base a la forme d'un rectangle allongé et **en ce qu'**elle porte plusieurs diodes électroluminescentes régulièrement espacées le long de la direction longitudinale de celle-ci.

## Patentansprüche

1. Beleuchtungsvorrichtung, umfassend wenigstens eine Leuchtdiode (13) und einen Kühlkörper zur Kühlung der Diode, **dadurch gekennzeichnet, dass** der Kühlkörper einen aus einem wärmeleitenden Material definierten Hauptkörper (17) mit U-förmigem Profil, der aus einer Basis (18) und aus zwei beabstandeten parallelen Streifen (20) besteht, und aus einem wärmeleitenden Material definierte Rippen (22), die in dem zwischen den beiden Streifen und der Basis begrenzten Raum parallel zueinander angeordnet sind, umfasst, und dass die Rippen durch wenigstens zwei wärmeleitende Distanzsysteme (25) voneinander beabstandet sind, dass jedes Distanzsystem mit seinen Enden an die parallelen Streifen des Hauptkörpers angeschlossen ist und eine Stange (29), die zu den parallelen Streifen des Hauptkörpers senkrecht verläuft und an diesen befestigt ist und Löcher (27) der Rippen durchgreift, sowie rohrförmige Abstandsstücke (31) aus wärmeleitendem Material umfasst, die auf die Stange (29) aufgesteckt und zwischen den Rippen in einer durch die Stange (29) eingespannten Montage, welche eine gute Leitung der Wärme zwischen dem Hauptkörper und den Rippen sicherstellt, angeordnet sind, wobei die Leuchtdiode mit Wärmekontakt an der Basis befestigt ist.

2. Vorrichtung nach Anspruch 1, **dadurch gekennzeichnet, dass** der Hauptkörper (17) aus einem im rechten Winkel entlang von zwei parallelen Linien gebogenen Metallblech ausgebildet ist.

3. Vorrichtung nach Anspruch 1 oder 2, **dadurch gekennzeichnet, dass** die Rippen (22) aus einem Metallblech ausgeschnittene Platten sind.

4. Vorrichtung nach einem der vorhergehenden Ansprüche, **dadurch gekennzeichnet, dass** die Stange (29) eine Schraube oder Gewindestange ist, die zwischen den parallelen Streifen (20) unter Einspannen der Abstandsstücke (31) und der Rippen (22) zwischen ihnen verschraubt ist.

5. Vorrichtung nach einem der vorhergehenden Ansprüche, **dadurch gekennzeichnet, dass** der Hauptkörper (17) aus Aluminium oder Legierung auf Aluminiumbasis besteht.

6. Vorrichtung nach einem der vorhergehenden Ansprüche, **dadurch gekennzeichnet, dass** die Rippen (22) aus Aluminium oder Legierung auf Aluminiumbasis bestehen.

7. Vorrichtung nach einem der vorhergehenden Ansprüche, **dadurch gekennzeichnet, dass** die rohrförmigen Abstandsstücke aus Kupfer, Messing oder ähnlichem bestehen.

8. Vorrichtung nach einem der vorhergehenden Ansprüche, **dadurch gekennzeichnet, dass** die Löcher einer jeden vorgenannten Rippe sich bis zu einem Rand derer erstrecken, wodurch sie einen offenen Schlitz bilden, um das Einsetzen der Rippen zwischen den Abstandsstücken vor Einspannen der Schraube oder Gewindestange zu erleichtern.

9. Vorrichtung nach einem der vorhergehenden Ansprüche, **dadurch gekennzeichnet, dass** wenigstens eine Rippe (22a) ein L-förmiges Profil aufweist, um einen sich längs erstreckenden langgestreckten Sockel (33) zu definieren, und dass dieser langgestreckte Sockel an der Basis (18) des Hauptkörpers mit U-förmigem Profil befestigt ist.

10. Vorrichtung nach einem der vorhergehenden Ansprüche, **dadurch gekennzeichnet, dass** die Basis (18) Löcher (35), vorzugsweise Schlitze umfasst, um die Wärmeaustäusche mit den Rippen durch Luftkonvektion zu begünstigen.

11. Vorrichtung nach einem der vorhergehenden Ansprüche, **dadurch gekennzeichnet, dass** die Basis (18) im Wesentlichen viereckig ist und dass sie wenigstens eine Leuchtdiode, die im Wesentlichen in ihrer Mitte angebracht ist, trägt.

12. Vorrichtung nach einem der Ansprüche 1 bis 10, **dadurch gekennzeichnet, dass** die Basis die Form eines langgestreckten Rechtecks aufweist und dass sie mehrere Leuchtdioden, die entlang der Längsrichtung dieser gleichmäßig beabstandet sind, trägt.

## Claims

1. A lighting device comprising at least one electroluminescent diode (13) and a cooling radiator of said diode, **characterized in that** the radiator comprises a main body (17) with U-shaped profile formed by a base (18) and two spaced parallel bands (20) defined in a thermally conductive material and fins (22) defined in a thermally conductive material, arranged parallel to one another in the space delimited between the two bands and said base and **in that** said fins are spaced apart from each other by at least two thermally conductive bracing systems (25), **in that** each bracing system is connected by its ends to said parallel bands and comprises a rod (29) extending perpendicularly to said bands and fixed thereto, and passing through holes (27) of the fins, and tubular spacers (31) in a thermally conductive material engaged on said rod (29) and disposed between the fins according to an assembly tightened by the rod (29) ensuring a good heat conduction between the main body and the fins, said electroluminescent diode being fixed with thermal contact to said base.

2. The device as claimed in Claim 1, **characterized in that** said main body (17) is made from a metal sheet folded at a right angle according to two parallel lines.

3. The device as claimed in Claim 1 or 2, **characterized in that** said fins (22) are plates cut out from a metal sheet.

4. The device according to any one of the previous claims, **characterized in that** said rod (29) is a screw or threaded rod, bolted between said parallel bands (20) and tightening the spacers (31) and the fins (22) together.

5. The device according to any one of the previous claims, **characterized in that** said main body (17) is made of aluminium or aluminium-based alloy.

6. The device according to any one of the previous claims, **characterized in that** said fins (22) are made of aluminium or aluminium-based alloy.

7. The device according to any one of the previous claims, **characterized in that** said tubular spacers are made of copper, brass or the like.

8. The device according to any one of the previous claims, **characterized in that** the holes of each abovementioned fin extend as far as an edge of the latter, forming an open slot, to make it easier to insert the fins between the spacers prior to tightening of said screw or threaded rod.

9. The device according to any one of the previous claims, **characterized in that** at least one fin (22a) has an L-shaped profile so as to define an elongated flange (33) extending longitudinally and **in that** this elongated flange is fixed to the base (18) of said main body with U-shaped profile.

10. The device according to any one of the previous claims, **characterized in that** said base (18) comprises holes (35), preferably slots for better thermal exchange with the fins, via air convection.

11. The device according to any one of the previous claims, **characterized in that** said base (18) is substantially square and **in that** it bears at least one electroluminescent diode mounted substantially in its centre.

12. The device according to any one of the previous claims, **characterized in that** said base has the shape of an elongated rectangle and **in that** it bears several electroluminescent diodes evenly spaced in the longitudinal direction thereof.
